# EUROPEAN PATENT APPLICATION

(11) **EP 3 312 989 A1**
(43) Date of publication of application: **25.04.2018**
(21) Application number: 15895511.2
(22) Date of filing: 29.12.2015
(51) Int. Cl.: H02S 30/10, H01L 31/048

(54) **LIGHTWEIGHT SOLAR CELL ASSEMBLY WITH HIGH MECHANICAL LOAD RESISTANCE**

(30) Priority: 19.06.2015 CN 201510344915
(71) Applicant: Suzhou Talesun Solar Technologies Co., Ltd., Shuzhou City, Jiangsu 215542 (CN)
(72) Inventor: NI, Zhichun, Suzhou Jiangsu 215542 (CN); CAI, Xia, Suzhou Jiangsu 215542 (CN); WEI, Qingzhu, Suzhou Jiangsu 215542 (CN); XU, Zhixiang, Suzhou Jiangsu 215542 (CN); HU, Leizhen, Suzhou Jiangsu 215542 (CN); ZHANG, Caixia, Suzhou Jiangsu 215542 (CN)
(74) Representative: Detken, Andreas
(86) International application number: PCT/CN2015/099342
(87) International publication number: WO 2016/201946

(57) **Abstract**

Disclosed is a lightweight solar cell module with high mechanical load resistance, comprising a solar cell string (1), EVA layers (2) stacked on two sides of the solar cell string, a front panel glass layer (3) stacked on one of the EVA layers, a back panel (4) stacked on the other of the EVA layers, frames (7) for clamping the back panel and the front panel glass layer, and a junction box (6) mounted on the back panel for connecting the solar cell strings and external circuits, wherein the front panel glass layer is made of super clear patterned glass, and at least one reinforcing rib (5) is mounted inside the frames. On the one hand, arranging at least one reinforcing rib between the back panel and the frames can effectively improve the capability of mechanical load resistance of the cell module, and on the other hand, setting the front panel glass to be super clear patterned glass can beneficially reduce the weight of the cell module, and improve the photoelectric conversion efficiency thereof.

## Description

This application claims the priority to Chinese Patent Application No.201510344915.9, titled "LIGHTWEIGHT SOLAR CELL MODULE WITH HIGH MECHANICAL LOAD RESISTANCE" and filed with the State Intellectual Property Office of the People's Republic of China on June 19, 2015, which is incorporated herein by reference in its entirety.

### FIELD OF THE INVENTION

The present disclosure relates to the field of photovoltaic crystalline silicon solar cell, and in particular to a lightweight solar cell module with high mechanical load resistance.

### BACKGROUND OF THE INVENTION

Solar energy is a kind of inexhaustible and renewable energy for human, and is also a kind of clean energy which does not produce any environment pollution. Among all kinds of effective solar energy utilization, solar energy photoelectric utilization is one of the fastest developed and the most dynamic research fields. A crystalline silicon solar cell is mainly based on semiconductor material, with the working principle of converting light energy to electric energy directly by the photoelectric conversion reaction with the light energy absorbed by the photoelectric material.

At present, the main structure of a conventional crystalline silicon solar cell module includes a toughened glass layer, EVA layers (Ethylene and Vinyl Acetate block copolymer), cells, a back sheet and an aluminum alloy frame. The whole module has an overall weight of approximately 20kg, which cannot be applied in a case involving, for example, a roof with a poor bearing capability and thus has a limited application scope. Besides, a conventional crystalline silicon solar cell module is heavy and is not convenient to carry and transport. On account of the foregoing disadvantages of a conventional crystalline silicon solar cell module, a lightweight module has been developed in the industry recently. However, due to its design defects, the lightweight module may loss the mechanical load capability, i.e., having a relatively weak capability of resisting a mechanical load, such as a snow load, a wind load, and the like. Therefore, it is extremely urgent to develop a crystalline silicon lightweight solar cell module which can not only meet requirements of lightweight, convenient transportation and good portability but also have a high capability of snow load resistance and wind load resistance, and moreover, which can be totally produced on a basis of the current crystalline silicon module process.

### SUMMARY OF THE INVENTION

The objective of the present disclosure is to overcome disadvantages in the prior art and provide a lightweight solar cell module with high mechanical load resistance.

In order to attain the foregoing objective, the technical solution provided in the present disclosure is as follows. A lightweight solar cell module with high mechanical load resistance includes a solar cell string, EVA layers stacked on two sides of the solar cell string, a front panel glass layer stacked on one of the EVA layers, a back sheet stacked on the other of the EVA layers, a frame for clamping the back sheet and the front panel glass layer, and a junction box mounted on the back sheet for connecting the solar cell string to an external circuit, where the front panel glass layer is made of super clear patterned glass, and at least one reinforcing rib is mounted on the frame.

Preferably, material for both the frame and the reinforcing rib is aluminum alloy.

Further, the frame includes a frame body and at least two clamping frames which are molded in one piece with the frame body and are located on inner side face of the frame body. The front panel glass layer and the back sheet are clamped between the clamping frames.

Further, there are three clamping frames, which are formed respectively at the top, at the bottom and in the middle of inner side face of the frame body. It is defined that the clamping frame formed at the top of inner side face of the frame body is a first clamping frame, the clamping frame formed in the middle of inner side face of the frame body is a second clamping frame and the clamping frame formed at the bottom of inner side face of the frame body is a third clamping frame. The front panel glass layer and the back sheet are clamped between the first clamping frame and the second clamping frame, and the reinforcing rib is installed between the second clamping frame and the third clamping frame.

Further, the reinforcing rib includes a first supporting plate, a vertical supporting plate vertical to the first supporting plate and a second supporting plate parallel to the first supporting plate. The vertical supporting plate is fixed between the first supporting plate and the second supporting plate, and the second supporting plate is attached to the third clamping frame in a detachable manner.

Further, the second supporting plate is attached to the third clamping frame in a detachable manner through a screw.

Further, a width of the second supporting plate is larger than a width of the first supporting plate.

Further, a height of the frame body ranges from 25mm to 30mm; a width of the third clamping frame ranges from 25mm to 30mm; a thickness of the front panel glass layer ranges from 0.8mm to 2.5mm.

Preferably, an outer surface of the front panel glass layer is adhered with an antireflection film.

Preferably, the solar cell string is formed by at least two solar cells connected in series by at least one solder strip.

With the foregoing technical solutions, the present disclosure has following advantages compared to the prior art. In the lightweight solar cell module with high mechanical load resistance provided according to the present disclosure, at least one reinforcing rib is arranged between the back sheet and the frame, which can effectively improve the capability of mechanical load resistance of the cell module. Furthermore, the front panel glass is implemented as super clear patterned glass, which can reduce the weight of the cell module while improving the photoelectric conversion efficiency.

### BRIEF DESCRIPTION OF THE DRAWINGS

Figure 1 is a structural schematic diagram illustrating a lightweight solar cell module with high mechanical load resistance according to a first embodiment of the present disclosure;
Figure 2 is a structural schematic diagram illustrating a lightweight solar cell module with high mechanical load resistance according to a second embodiment of the present disclosure; and
Figure 3 is a structural schematic diagram illustrating a reinforcing rib of a lightweight solar cell module with high mechanical load resistance according to the present disclosure.
Reference numerals: 1 solar cell string; 11 solar cell; 12 solder strip; 2 EVA layer; 3 front panel glass layer; 4 back sheet; 5 reinforcing rib; 51 first supporting plate; 52 vertical supporting plate; 53 second supporting plate; 6 junction box; 7 frame; 71 frame body; 72 first clamping frame; 73 second clamping frame; 74 third clamping frame.

### DETAILED DESCRIPTION OF THE EMBODIMENTS

The preferred embodiments of the present disclosure are described clearly and completely as follows in conjunction with the accompany drawings.

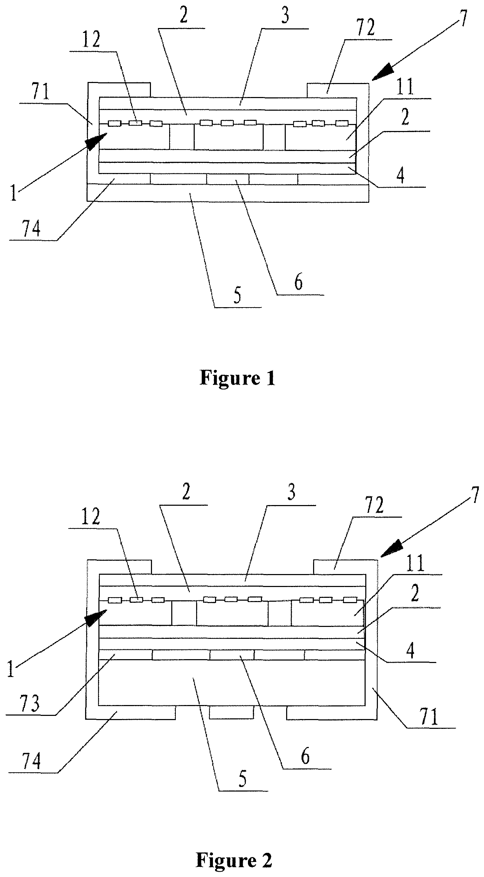

As shown in Figure 1 and Figure 2, a lightweight solar cell module with high mechanical load resistance mainly includes: a solar cell string 1, EVA layers 2, a front panel glass layer 3, a back sheet 4, a reinforcing rib 5, a junction box 6 and a frame 7.

The solar cell string 1 is formed by at least two solar cells 11 connected in series by at least one solder strip 12. The solder strip 12 is connected from the front of a solar cell 11 to the back of another solar cell 11. There are two EVA layers 2, which are stacked on two sides of the solar cell string 1respectively. The front panel glass layer 3 is stacked on one of the EVA layers 2. The front panel glass layer 3 is made of the material of super clear patterned glass and has a preferred thickness of 0.8-2.5mm, which is beneficial not only to reducing the weight of the cell module, but also to receiving the incident sunlight to improve the photoelectric conversion efficiency. A back sheet 4 is stacked on the other of the EVA layers 2. The frame 7 clamps the back sheet 4 and the front panel glass layer 3. The frame 7 includes a frame body 71 and at least two clamping frames which are molded in one piece with the frame body 71 and are located on inner side face of the frame body. The front panel glass layer 3 and the back sheet 4 are clamped between the clamping frames. The junction box 6 is mounted on the back sheet 4 for connecting the solar cell string 1 to an external circuit. At least one reinforcing rib 5 mounted on the frame 7. Material of both the frame 7 and the reinforcing rib 5 is aluminum alloy to improve the capability of mechanical load resistance of the cell module. The number of the reinforcing rib 5 may be adjusted according to a specific requirement of mechanical load resistance, which may be in a range of 5400Pa to 8000Pa. The lightweight solar cell module with high mechanical load resistance may have the following two embodiments of different structures of the frame 7, which are described in detail below.

### First embodiment

A lightweight solar cell module with high mechanical load resistance is provided in this embodiment. The general structure of the solar cell module is as shown in the above. The difference lies in that there are two clamping frames formed respectively at the top and bottom of inner side face of the frame body 71. The clamping frame formed at the top of inner side face of the frame body 71 is defined as a first clamping frame 72, and the clamping frame formed at the bottom of inner side face of the frame body 71 is defined as a third clamping frame 74. The front panel glass layer 3 and the back sheet 4 are clamped between the first clamping frame 72 and the third clamping frame 74, and the reinforcing rib 5 is installed on the third clamping frame 74.

### Second embodiment

A lightweight solar cell module with high mechanical load resistance is provided in this embodiment. The general structure of the solar cell module is as shown in the above. The difference lies in that there are three clamping frames formed respectively at the top, at the bottom and in the middle of inner side face of the frame body 71. The clamping frame formed at the top of inner side face of the frame body 71 is defined as a first clamping frame 72, the clamping frame formed in the middle of inner side face of the frame body 71 is defined as a second clamping frame 73, and the clamping frame formed at the bottom of inner side face of the frame body 71 is defined as a third clamping frame 74. The front panel glass layer 3 and the back sheet 4 are clamped between the first clamping frame 72 and the second clamping frame 73, and the reinforcing rib 5 is installed between the second clamping frame 73 and the third clamping frame 74.

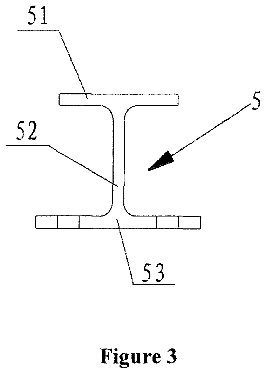

In this embodiment, as shown in Figure 3, the reinforcing rib 5 includes: a first supporting plate 51, a vertical supporting plate 52 vertical to the first supporting plate 51 and a second supporting plate 53 parallel to the first supporting plate 51. The vertical supporting plate 52 is fixed between the first supporting plate 51 and the second supporting plate 53, and the second supporting plate 53 is attached to the third clamping frame 74 in a detachable manner through a screw. In this way, not only the solar cell module is convenient to assemble, but also the capability of mechanical load resistance of the whole solar cell module can be further improved while reducing the weight of the reinforcing rib 5. Furthermore, the width of a second supporting plate 53 is large than the width of a first supporting plate 51, to improve the contact area between the second supporting plate 53 and the third clamping frame 74, so as to alleviate the pressure between the second supporting plate 53 and the third clamping frame 74, thereby further improving the capability of mechanical load resistance of the whole solar cell module. The height of the frame body 71 ranges from 25mm to 30mm and the width of the third clamping frame 74 ranges from 25mm to 30mm, while in a traditional frame 7, the height of the frame body 71 is approximately 40mm and the width of the third clamping frame 74 is 35mm. Apparently, the solar cell module in this embodiment is much lighter. In this embodiment, an outer surface (that is, the surface which is not in contact with the EVA layer 2) of the front panel glass layer 3 is adhered with an antireflection film, to increase the quantity of incident sunshine to the solar cell module and thus increase the amount of current generated by conversion performed by the solar cell module.

The foregoing embodiments are only to describe technical ideas and features, to make those skilled in the art to understand content of the disclosure and perform implementation based on the above embodiments. The embodiments are not meant to limit the scope of the disclosure. All equivalent alternations or modifications made according to the spirit of the disclosure should fall within the scope of the disclosure.

## Claims

1. A lightweight solar cell module with high mechanical load resistance, comprising:
a solar cell string,
EVA layers stacked on two sides of the solar cell string,
a front panel glass layer stacked on one of the EVA layers,
a back sheet stacked on the other of the EVA layers,
a frame for clamping the back sheet and the front panel glass layer, and
a junction box mounted on the back sheet for connecting the solar cell string to an external circuit, wherein
the front panel glass layer is made of super clear patterned glass, and at least one reinforcing rib is mounted on the frame.

2. The lightweight solar cell module with high mechanical load resistance according to claim 1, wherein material of both the frame and the reinforcing rib is aluminum alloy.

3. The lightweight solar cell module with high mechanical load resistance according to claim 1 or 2, wherein
the frame comprises: a frame body and at least two clamping frames which are molded in one piece with the frame body and are located on inner side face of the frame body; and
the front panel glass layer and the back sheet are clamped between the clamping frames.

4. The lightweight solar cell module with high mechanical load resistance according to claim 3, wherein
the number of the clamping frames is three, the clamping frames are formed respectively at the top, at the bottom and in the middle of inner side face of the frame body;
the clamping frame formed at the top of inner side face of the frame body is defined as a first clamping frame, the clamping frame formed in the middle of inner side face of the frame body is defined as a second clamping frame, and the clamping frame formed at the bottom of inner side face of the frame body is defined as a third clamping frame, the front panel glass layer and the back sheet are clamped between the first clamping frame and the second clamping frame, and the reinforcing rib is installed between the second clamping frame and the third clamping frame.

5. The lightweight solar cell module with high mechanical load resistance according to claim 4, wherein
the reinforcing rib comprises: a first supporting plate, a vertical supporting plate vertical to the first supporting plate, and a second supporting plate parallel to the first supporting plate;
the vertical supporting plate is fixed between the first supporting plate and the second supporting plate, and the second supporting plate is attached to the third clamping frame in a detachable manner.

6. The lightweight solar cell module with high mechanical load resistance according to claim 5, wherein the second supporting plate is attached to the third clamping frame in a detachable manner through a screw.

7. The lightweight solar cell module with high mechanical load resistance according to claim 5, wherein a width of the second supporting plate is larger than a width of the first supporting plate.

8. The lightweight solar cell module with high mechanical load resistance according to claim 4, wherein
a height of the frame body ranges from 25mm to 30mm;
a width of the third clamping frame ranges from 25mm to 30mm; and
a thickness of the front panel glass layer ranges from 0.8mm to 2.5mm.

9. The lightweight solar cell module with high mechanical load resistance according to claim 1, wherein an outer surface of the front panel glass layer is adhered with an antireflection film.

10. The lightweight solar cell module with high mechanical load resistance according to claim 1, wherein the solar cell string is formed by at least two solar cells connected in series by at least one solder strip.
